(19) Europäisches Patentamt
European Patent Office
Office européen des brevets

(11) **EP 2 927 973 A1**

(12) **EUROPEAN PATENT APPLICATION**
published in accordance with Art. 153(4) EPC

(43) Date of publication:
**07.10.2015 Bulletin 2015/41**

(21) Application number: **13858367.9**

(22) Date of filing: **28.11.2013**

(51) Int Cl.:
*H01L 35/32* (2006.01)    *C22C 5/08* (2006.01)
*C22C 9/00* (2006.01)    *C22C 9/01* (2006.01)
*C22C 9/04* (2006.01)    *C22C 9/10* (2006.01)
*C22C 12/00* (2006.01)    *C22C 19/05* (2006.01)
*C22C 19/07* (2006.01)    *C22C 21/00* (2006.01)
*C22C 21/12* (2006.01)    *C22C 27/02* (2006.01)
*C22C 27/04* (2006.01)    *C22C 27/06* (2006.01)
*H01L 35/08* (2006.01)    *H01L 35/18* (2006.01)

(86) International application number:
**PCT/JP2013/082063**

(87) International publication number:
**WO 2014/084315 (05.06.2014 Gazette 2014/23)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **28.11.2012 JP 2012260243**

(71) Applicant: **Furukawa Co., Ltd.**
**Chiyoda-ku**
**Tokyo 100-8370 (JP)**

(72) Inventors:
• **SUZUKI Shogo**
**Tsukuba-shi**
**Ibaraki 305-0856 (JP)**

• **KIKUCHI Masaaki**
**Tsukuba-shi**
**Ibaraki 305-0856 (JP)**
• **OCHI Takahiro**
**Tsukuba-shi**
**Ibaraki 305-0856 (JP)**
• **ITO Satoru**
**Tsukuba-shi**
**Ibaraki 305-0856 (JP)**
• **GUO Junqing**
**Tsukuba-shi**
**Ibaraki 305-0856 (JP)**

(74) Representative: **Schnappauf, Georg**
**ZSP Patentanwälte**
**Partnerschaftsgesellschaft**
**Radlkoferstrasse 2**
**81373 München (DE)**

(54) **THERMOELECTRIC CONVERSION MODULE**

(57) A thermoelectric conversion module includes a p-type thermoelectric conversion member (111) and an n-type thermoelectric conversion member (112) that contain Sb, and an electrode member (120) that is joined to the p-type thermoelectric conversion member (111) and the n-type thermoelectric conversion member (112), composed of an alloy of Cu and a metal material M1 having a lower thermal expansion coefficient than that of Cu, and includes two or more crystalline phases composed of Cu and M1. Therefore, it is possible to improve durability while realizing the properties required for the thermoelectric conversion module.

FIG. 1

**Description**

TECHNICAL FIELD

The present invention relates to a thermoelectric conversion module.

BACKGROUND ART

A thermoelectric conversion module includes, for example, a thermoelectric conversion member capable of converting thermal energy into electrical energy or converting electrical energy into thermal energy, and an electrode to be joined to the thermoelectric conversion member. Technologies related to such a thermoelectric conversion module are examined in various ways and examples thereof include Patent Documents 1 to 3.

The technology described in Patent Document 1 is for joining a thermoelectric conversion member and an electrode member using a joining member having a thermal stress relaxation layer and a diffusion prevention layer. In Patent Document 2, a thermoelectric conversion material having a structure expressed by Formula $R_r T_{t-m} M_m X_{x-n} N_n$ and a thermoelectric conversion module including the same are described. In Patent Document 3, a thermoelectric conversion material is connected to an electrode by single step sintering.

[Patent Document 1] Japanese Unexamined Patent Publication No. 2011-249492
[Patent Document 2] Pamphlet of International Publication No. WO2009/093455
[Patent Document 3] PCT Japanese Translation Patent Publication No. 2012-522380

DISCLOSURE OF THE INVENTION

As for a thermoelectric conversion module, from the viewpoint of using various kinds of waste heat, there is a case in which it is required to improve thermoelectric performance over a wide temperature range from room temperature to 600°C. In this case, as a thermoelectric conversion member, for example, a member composed of a material containing Sb is used.

On the other hand, it is preferable that the difference in thermal expansion coefficient between the thermoelectric conversion member and the electrode member be reduced in the thermoelectric conversion module from the viewpoint of improving the durability thereof. However, it is difficult to accurately adjust the balance between the properties required for the thermoelectric conversion module such as thermal conductivity and the thermal expansion coefficient.

According to the present invention, there is provided a thermoelectric conversion module including a thermoelectric conversion member that contains Sb, and an electrode member that is joined to the thermoelectric conversion member, composed of an alloy of Cu and a metal material M1 having a lower thermal expansion coefficient than that of Cu, and includes two or more crystalline phases composed of Cu and the metal material M1.

According to the present invention, it is possible to improve durability while realizing the properties required for the thermoelectric conversion module.

BRIEF DESCRIPTION OF THE DRAWINGS

The above and other objects, features and advantages of the present invention will be more apparent from the following description of certain preferred embodiments taken in conjunction with the accompanying drawings.
FIG. 1 is a schematic front view showing a thermoelectric conversion module according to a first embodiment.
FIG. 2 is a schematic front view showing a thermoelectric conversion module according to a second embodiment.
FIG. 3 is an SEM image (backscattered electron image) showing a phase-separated structure of an electrode member.

DESCRIPTION OF EMBODIMENTS

Hereinafter, embodiments of the present invention will be described with reference to the drawings. In addition, the same reference numerals are used for the same components throughout all the drawings, and the description thereof will be omitted.

(First Embodiment)

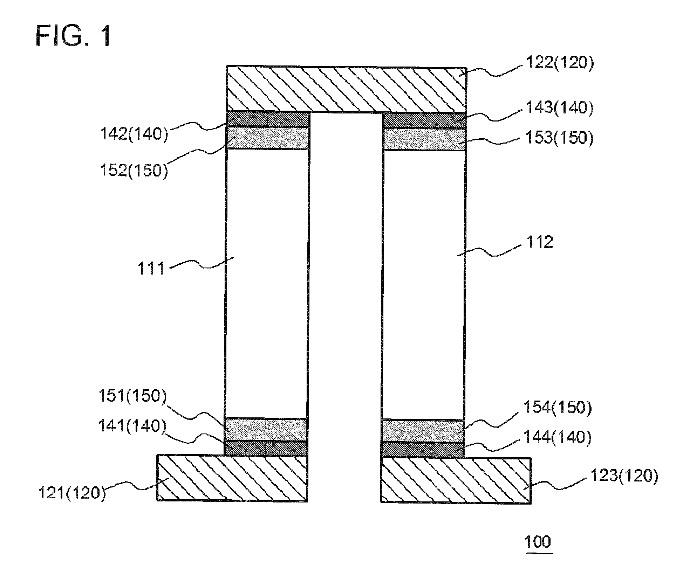

FIG. 1 is a schematic front view showing a thermoelectric conversion module 100 according to a first embodiment.

The thermoelectric conversion module 100 according to the embodiment includes a thermoelectric conversion member, and an electrode member that is joined to the thermoelectric conversion member. The thermoelectric conversion member contains Sb. The electrode member is composed of an alloy of Cu and a metal material M1 having a lower thermal expansion coefficient than that of Cu. In addition, the electrode member includes two or more crystalline phases composed of Cu and the metal material M1.

According to the embodiment, the electrode member to be joined to the thermoelectric conversion member is composed of an alloy of Cu and a metal material M1 having a lower thermal expansion coefficient than that of Cu. When the electrode member contains Cu, an electrode member having good thermal conductivity and electrical conductivity can be realized. Therefore, the power generation properties of the thermoelectric conversion module can be improved.

In addition, the electrode member has the metal material M1 having a lower thermal expansion coefficient than that of Cu. Therefore, even when the electrode member includes Cu having a higher thermal expansion coefficient than that of Sb, a difference in thermal expansion coefficient between the electrode member and the thermoelectric conversion member can be reduced. Accordingly, the durability of the thermoelectric conversion module can be improved.

In addition, the inventors have found that when a metal material constituting an electrode member has a phase-separated structure, the thermal expansion coefficient of the electrode member can accurately be adjusted. The electrode member in the embodiment includes two or more crystalline phases composed of Cu and the metal material M1. Therefore, the balance between the properties required for the thermoelectric conversion module such as thermal conductivity and the thermal expansion coefficient can be accurately adjusted.

Thus, according to the embodiment, it is possible to improve durability while realizing the properties required for the thermoelectric conversion module.

Hereinafter, the configuration of the thermoelectric conversion module 100 according to the embodiment and the manufacturing method thereof will be described in detail.

First, the configuration of the thermoelectric conversion module 100 according to the embodiment will be described.

The thermoelectric conversion module 100 according to the embodiment includes a p-type thermoelectric conversion member 111 and an n-type thermoelectric conversion member 112. For example, the thermoelectric conversion module 100 is configured such that plural pairs of p-type thermoelectric conversion members 111 and n-type thermoelectric conversion members 112 are electrically connected to one another in series. At this time, the plural p-type thermoelectric conversion members 111 and the plural n-type thermoelectric conversion members 112 are arranged such that the p-type thermoelectric conversion members 111 and the n-type thermoelectric conversion members 112 are alternately connected to one another. The thermoelectric conversion module 100 of the embodiment has a size of, for example, an area of 50 mm×50 mm and a height of 6 mm to 10 mm.

For example, the p-type thermoelectric conversion member 111 and the n-type thermoelectric conversion member 112 have a prismatic columnar shape.

The p-type thermoelectric conversion member 111 and the n-type thermoelectric conversion member 112 contain Sb. Thus, the thermoelectric conversion module 100 can be realized in which good thermoelectric properties are exhibited over a wide temperature range and particularly, high thermoelectric properties are exhibited in an intermediate temperature range of equal to or more than 300°C and equal to or less than 600°C.

The properties of the thermoelectric conversion material are evaluated by, for example, using a dimensionless figure of merit ZT using a figure of merit Z and a temperature T (here, the temperature T refers to the absolute temperature) as an index. As the dimensionless figure of merit ZT increases, higher thermoelectric performance at the temperature T is obtained. The figure of merit Z is expressed by the following Expression (1) using a Seebeck coefficient S, a thermal conductivity $\kappa$ and an electric resistivity $\rho$.

$$Z = S^2 / (\kappa\rho) \qquad (1)$$

Therefore, the dimensionless figure of merit ZT is expressed by the following Expression (2).

$$ZT = S^2 T / (\kappa\rho) \qquad (2)$$

In the embodiment, the p-type thermoelectric conversion member 111 and the n-type thermoelectric conversion member 112 are composed of, for example, a filled skutterudite compound. In this case, higher thermoelectric performance can be realized in the intermediate temperature range.

As the filled skutterudite compound, for example, a compound expressed by the formula $R_rT_{t-m}M_mSb_{x-n}N_n$ ($0 \leq r \leq 1$, $3 \leq t-m \leq 5$, $0 \leq m \leq 0.5$, $10 \leq x \leq 15$, $0 \leq n \leq 2$) can be used. R represents three or more elements selected from the group consisting of rare earth elements, alkali metal elements, alkaline-earth metal elements, group 4 elements, and group 13 elements. T represents at least one element selected from Fe, Co and Ni. M represents at least one element selected from the group consisting of Ti, V, Cr, Mn, Cu, Zn, Ag and Au. N represents at least one element selected from the group consisting of P, As, Bi, O, S, Se, Te, C, Si, Ge, Sn and Pb.

In the embodiment, the p-type thermoelectric conversion member 111 and the n-type thermoelectric conversion member 112 may be composed of a non-filled skutterudite compound which is a binary compound.

The p-type thermoelectric conversion member 111 and the n-type thermoelectric conversion member 112 are composed of, for example, different materials from each other. In the embodiment, the p-type thermoelectric conversion member 111 is preferably composed of a filled skutterudite compound expressed by $(La, Ba, Ga, Ti)_{0.7 \text{ to } 1.0}(Fe, Co)_4Sb_{12}$. In addition, the n-type thermoelectric conversion member 112 is preferably composed of a filled skutterudite compound expressed by $(Yb, Ca, Al, Ga, In)_{0.5 \text{ to } 0.8}(Fe, Co)_4Sbi_2$.

The thermal expansion coefficients of the p-type thermoelectric conversion member 111 and the n-type thermoelectric conversion member 112 are, for example, equal to or more than $8 \times 10^{-6}$ (/K) and equal to or less than $15 \times 10^{-6}$ (/K) in a range of equal to or more than 20 °C and equal to or less than 600°C.

The thermoelectric conversion module 100 includes an electrode member 120. The electrode member 120 is joined to the p-type thermoelectric conversion member 111 and the n-type thermoelectric conversion member 112.

In the embodiment, the electrode member 120 includes, for example, an electrode member 121, an electrode member 122 and an electrode member 123. The electrode member 122 connects the p-type thermoelectric conversion member 111 and the n-type thermoelectric conversion member 112, which constitute one pair. The electrode member 121 connects the p-type thermoelectric conversion member 111 which constitutes one pair to the n-type thermoelectric conversion member 112 which constitutes another pair. The electrode member 123 connects the n-type thermoelectric conversion member 112 which constitutes one pair to the p-type thermoelectric conversion member 111 which constitutes another pair.

For example, the electrode member 120 is provided in a flat plate shape. In this case, the electrode member 120 has, for example, a size of 5 mm×11 mm×0.5 mm to 2.0 mm.

In the thermoelectric conversion module 100 according to the embodiment, the p-type thermoelectric conversion member 111, the n-type thermoelectric conversion member 112 and the electrode member 120 have a n-shaped connection structure.

In the π-shaped connection structure, the p-type thermoelectric conversion member 111 and the n-type thermoelectric conversion member 112 are arranged in parallel with each other. Here, as for each of the p-type thermoelectric conversion member 111 and the n-type thermoelectric conversion member 112, one end is disposed on a high temperature side (upper side in FIG. 1) and the other end is disposed on a low temperature side (lower side in FIG. 1). The one end of each of the p-type thermoelectric conversion member 111 and the n-type thermoelectric conversion member 112 is connected to the flat plate-like electrode member 120 disposed on the high temperature side. Further, the other end of each of the p-type thermoelectric conversion member 111 and the n-type thermoelectric conversion member 112 is connected to the flat plate-like electrode member 120 disposed on the low temperature side. In the embodiment, for example, the electrode member 122 is arranged on the high temperature side, and the electrode member 121 and the electrode member 123 are arranged on the low temperature side.

The electrode member 120 is composed of an alloy of Cu and a metal material M1 having a lower thermal expansion coefficient than that of Cu. The alloy refers to a metal material composed of two or more metal elements. In the embodiment, the alloy includes alloy materials having a phase-separated structure composed of two or more crystalline phases.

When the electrode member 120 includes Cu, the thermal conductivity and electrical conductivity of the electrode member can be improved. The thermal conductivity of the electrode member 120 of the embodiment is, for example, equal to or more than 50 W/mK and equal to or less than 400 W/mK at room temperature. In addition, the electrical conductivity of the electrode member 120 is, for example, equal to or more than $1 \times 10^6$ S/m and equal to or less than $6 \times 10^7$ S/m.

Further, the electrode member 120 has the metal material M1 having a lower thermal expansion coefficient than that of Cu. Therefore, the thermal expansion coefficient of the electrode member 120 can be reduced. Accordingly, even when the electrode member includes Cu having a higher thermal expansion coefficient than that of Sb, the difference in thermal expansion coefficient between the electrode member and the thermoelectric conversion member can be reduced. The thermal expansion coefficient of the electrode member 120 is, for example, equal to or more than $8 \times 10^{-6}$ (/K) and equal to or less than $15 \times 10^{-6}$ (/K) in a range of equal to or more than 20°C and equal to or less than 600°C.

In the embodiment, the difference in thermal expansion coefficient between the electrode member 120 and the p-type thermoelectric conversion member 111 in a range of equal to or more than 20°C and equal to or less than 600°C is, for example, equal to or less than 20% of the thermal expansion coefficient of the p-type thermoelectric conversion member 111. In addition, the difference in thermal expansion coefficient between the electrode member 120 and the n-type thermoelectric conversion member 112 in a range of equal to or more than 20°C and equal to or less than 600°C is, for example, equal to or less than 20% of the thermal expansion coefficient of the n-type thermoelectric conversion member 112. Thus, it is possible to improve the durability of the thermoelectric conversion module while maintaining satisfactory joining of the electrode member and the thermoelectric conversion member.

Here, the difference in thermal expansion coefficient between the electrode member and the thermoelectric conversion member refers to an absolute value of a difference between the thermal expansion coefficient of the electrode member and the thermal expansion coefficient of the thermoelectric conversion member.

In the embodiment, for example, the metal material M1 is composed of at least one element selected from the group consisting of Cr, Mo, W, V, Nb and Ta. Thus, the difference in thermal expansion coefficient between the electrode member 120 and the p-type thermoelectric conversion member 111 and the difference in thermal expansion coefficient between the electrode member 120 and the n-type thermoelectric conversion member 112 can be sufficiently reduced. Further, when Cr is used as the metal material M1 constituting the electrode member 120, the manufacturing costs can be reduced.

In the embodiment, the content of the metal material M1 in the electrode member 120 is, for example, equal to or more than 5 wt% and less than 90 wt%. When the metal material M1 is Cr, the content of Cr in the electrode member 120 is preferably equal to or more than 40 wt% and equal to or less than 65 wt%. When the metal material M1 is Mo, the content of Mo in the electrode member 120 is preferably equal to or more than 45 wt% and equal to or less than 70 wt %. When the metal material M1 is W, the content of W in the electrode member 120 is preferably equal to or more than 60 wt% and equal to or less than 75 wt%. When the metal material M1 is V, the content of V in the electrode member 120 is preferably equal to or more than 50 wt% and equal to or less than 75 wt%. When the metal material M1 is Nb, the content of Nb in the electrode member 120 is preferably equal to or more than 50 wt% and equal to or less than 75 wt%. When the metal material M1 is Ta, the content of Ta in the electrode member 120 is preferably equal to or more than 65 wt% and equal to or less than 80 wt%.

The electrode member 120 includes two or more crystalline phases composed of Cu and the metal material M1. These two or more crystalline phases have a structure in which the phases are separated from each other. Thus, the thermal expansion coefficient of the electrode member 120 can be accurately adjusted. Accordingly, the balance between the properties required for the thermoelectric conversion module such as thermal conductivity and the thermal expansion coefficient can be accurately adjusted.

In the embodiment, the electrode member 120 has, for example, a eutectic, eutectoid, peritectic, or peritectoid phase-separated structure composed of a crystalline phase having Cu as a main component and a crystalline phase having the metal material M1 as a main component. The phase-separated structure has a sea-island structure in which any one of the crystalline phase having Cu as a main component and the crystalline phase having the metal material M1 as a main component is formed like islands and the other is formed like the sea. Here, the island-like crystalline phase component has, for example, a spherical shape, a narrow and long flat shape, or a columnar shape. In addition, the sea-like crystalline phase component co-exists with the island-like component in a separated manner so as to wrap the island-like component having a spherical shape, a narrow and long flat shape, or a columnar shape.

In the embodiment, for example, in the sea-island structure including the crystalline phase having Cu as a main component and the crystalline phase having the metal material M1 as a main component, the maximum diameter of the circumscribed circle of the island-like component is equal to or less than 500 $\mu$m. In such a case, the inventors have found that the thermal expansion coefficient of the electrode member 120 can be more accurately adjusted. Therefore, a better balance between the properties required for the thermoelectric conversion module and the thermal expansion coefficient can be attained. In the embodiment, in the sea-island structure composed of the crystalline phase having Cu as a main component and the crystalline phase having the metal material M1 as a main component, the maximum diameter of the circumscribed circle of the island-like component is preferably equal to or less than 300 $\mu$m.

The phase-separated structure of the electrode member 120 is observed by using, for example, a scanning electron microscope (SEM). The maximum diameter of the circumscribed circle of the island-like component is, for example, calculated from an image obtained by the SEM.

In the electrode member 120 configuring the thermoelectric conversion module 100, from the viewpoint of stabilizing the properties, it is preferable to reduce the content of O. In the embodiment, the content of O in the electrode member 120 is, for example, equal to or less than 0.1 wt%. Thus, it is possible to stabilize the properties of the electrode member 120 such as thermal conductivity and electrical conductivity.

O included in the electrode member 120 is derived from the raw material of the electrode member 120, oxidation occurring when the electrode member 120 is prepared, and the like. The content of O in the electrode member 120 can be reduced by, for example, oxygen control when the electrode member 120 is prepared or hydrogen reduction treatment. For the oxygen control, for example, the electrode member 120 is prepared in an inert gas atmosphere.

In the electrode member 120 configuring the thermoelectric conversion module 100, from the viewpoint of stabilizing the properties, it is preferable to reduce the content of As. The content of As in the electrode member 120 is, for example, equal to or less than 0.05 wt%. Therefore, it is possible to stabilize the properties of the electrode member 120 such as thermal conductivity and electrical conductivity.

Further, As included in the electrode member 120 is derived from the raw material of the electrode member 120. The content of As in the electrode member 120 can be reduced by, for example, using a high purity raw material.

In the electrode member 120 configuring the thermoelectric conversion module 100, from the viewpoint of stabilizing the properties, it is preferable to reduce the content of Bi. The content of Bi in the electrode member 120 is, for example, equal to or less than 0.05 wt%. Therefore, it is possible to stabilize the properties of the electrode member 120 such as thermal conductivity and electrical conductivity.

Further, Bi included in the electrode member 120 is derived from the raw material of the electrode member 120. The content of Bi in the electrode member 120 can be reduced by, for example, using a high purity raw material.

In the electrode member 120 configuring the thermoelectric conversion module 100, from the viewpoint of stabilizing the properties, it is preferable to reduce the content of S. The content of S in the electrode member 120 is, for example, equal to or less than 0.05 wt%. Therefore, it is possible to stabilize the properties of the electrode member 120 such as thermal conductivity and electrical conductivity.

S included in the electrode member 120 is derived from the raw material of the electrode member 120. The content of S in the electrode member 120 can be reduced by, for example, using a high purity raw material.

In the electrode member 120 configuring the thermoelectric conversion module 100, from the viewpoint of stabilizing the properties, it is preferable to reduce the content of Sn. The content of Sn in the electrode member 120 is, for example, equal to or less than 0.05 wt%. Therefore, it is possible to stabilize the properties of the electrode member 120 such as thermal conductivity and electrical conductivity.

Sn included in the electrode member 120 is derived from the raw material of the electrode member 120. The content of Sn in the electrode member 120 can be reduced by, for example, using a high purity raw material.

The electrode member 120 is prepared by, for example, a casting method, a powder metallurgy method, a dipping method, a unidirectional solidification method, a rapid solidification method, a thermal spraying method, a deposition method, a rolling method, a forging method, an extrusion method, or a combination thereof. In the embodiment, for example, the electrode member 120 is prepared by mixing pure metal powders having a particle diameter of equal to or less than 200 $\mu$m, and then performing a spark plasma sintering method (a type of powder metallurgy method) at a temperature of 700°C to 1050°C and a pressure of 1 MPa to 60 MPa for a sintering time of 2 minutes to 60 minutes in a vacuum.

The thermoelectric conversion module 100 includes, for example, a thermal stress relaxation layer 140. The thermal stress relaxation layer 140 is provided between the electrode member 120 and the p-type thermoelectric conversion member 111 and between the electrode member 120 and the n-type thermoelectric conversion member 112.

In the embodiment, the thermal stress relaxation layer 140 includes, for example, a thermal stress relaxation layer 141, a thermal stress relaxation layer 142, a thermal stress relaxation layer 143 and a thermal stress relaxation layer 144. The thermal stress relaxation layer 141 is provided between the electrode member 121 and the p-type thermoelectric conversion member 111 so as to be in contact with the electrode member 121. The thermal stress relaxation layer 142 is provided between the electrode member 122 and the p-type thermoelectric conversion member 111 so as to be in contact with the electrode member 122. The thermal stress relaxation layer 143 is provided between the electrode member 122 and the n-type thermoelectric conversion member 112 so as to be in contact with the electrode member 122. The thermal stress relaxation layer 144 is provided between the electrode member 123 and the n-type thermoelectric conversion member 112 so as to be in contact with the electrode member 123.

The Young's modulus of the thermal stress relaxation layer 140 is lower than those of the electrode member 120, the p-type thermoelectric conversion member 111, and the n-type thermoelectric conversion member 112 at 25°C. That is, the thermal stress relaxation layer 140 is more easily deformed by stress than the electrode member 120, the p-type thermoelectric conversion member 111 and the n-type thermoelectric conversion member 112. Therefore, the stress due to the difference in thermal expansion coefficient between the electrode member 120 and the p-type thermoelectric conversion member 111 can be relaxed by the thermal stress relaxation layer 140. In addition, the stress due to the difference in thermal expansion coefficient between the electrode member 120 and the n-type thermoelectric conversion member 112 can be relaxed by the thermal stress relaxation layer 140. Accordingly, it is possible to prevent the electrode member and the thermoelectric conversion member from being damaged at the time of operation of the thermoelectric conversion module.

The Young's modulus of the thermal stress relaxation layer 140 at 25°C is, for example, equal to or less than 130 MPa. Therefore, the thermal stress relaxation layer 140 having a lower Young's modulus than those of the electrode member 120, the p-type thermoelectric conversion member 111 and the n-type thermoelectric conversion member 112 is easily realized.

For example, the thermal stress relaxation layer 140 is composed of at least one alloy selected from the group consisting of a Cu alloy, an Ag alloy and an Al alloy. In the embodiment, for example, the thermal stress relaxation layer 140 is composed of an alloy of a metal material M4 composed of at least one element selected from the group consisting of Cu, Ag and Al and a metal material M5 composed of at least one element selected from the group consisting of Ag, Au, Cu, Zn, Cd, Al, Ga, In, Si, Ge, Sn, Pb, P, Bi, Li, Mg, Cr, Ni, Ti, and Zr.

Accordingly, the electrode member 120 and a diffusion prevention layer 150, which will be described later, can be stably joined to each other. In addition, the thermal stress relaxation layer 140 having a lower Young's modulus than those of the electrode member 120, the p-type thermoelectric conversion member 111 and the n-type thermoelectric conversion member 112 can be easily realized.

The thermoelectric conversion module 100 includes, for example, a diffusion prevention layer 150. The diffusion prevention layer 150 is provided between the electrode member 120 and the p-type thermoelectric conversion member 111 and between the electrode member 120 and the n-type thermoelectric conversion member 112. In the embodiment, for example, the diffusion prevention layer 150 is provided between the thermal stress relaxation layer 140 and the p-type thermoelectric conversion member 111 and between the thermal stress relaxation layer 140 and the n-type thermoelectric conversion member 112.

The diffusion prevention layer 150 has a function of suppressing diffusion of the constituent component of the p-type thermoelectric conversion member 111 and the n-type thermoelectric conversion member 112 to the electrode member 120 and the thermal stress relaxation layer 140. Accordingly, aging deterioration caused by a reaction of the constituent component such as Sb included in the p-type thermoelectric conversion member 111 and the n-type thermoelectric conversion member 112 with the constituent components of other members can be suppressed. Therefore, the durability of the thermoelectric conversion module can be improved.

In the embodiment, for example, the diffusion prevention layer 150 includes a diffusion prevention layer 151, a diffusion prevention layer 152, a diffusion prevention layer 153 and a diffusion prevention layer 154.

For example, the diffusion prevention layer 151 and the diffusion prevention layer 152 are formed so as to be in contact with the p-type thermoelectric conversion member 111. The diffusion prevention layer 151 is provided between the thermal stress relaxation layer 141 and the p-type thermoelectric conversion member 111. In addition, the diffusion prevention layer 152 is provided between the thermal stress relaxation layer 142 and the p-type thermoelectric conversion member 111.

For example, the diffusion prevention layer 153 and the diffusion prevention layer 154 are formed so as to be in contact with the n-type thermoelectric conversion member 112. The diffusion prevention layer 153 is provided between the thermal stress relaxation layer 143 and the n-type thermoelectric conversion member 112. In addition, the diffusion prevention layer 154 is provided between the thermal stress relaxation layer 144 and the n-type thermoelectric conversion member 112.

For example, the diffusion prevention layer 150 is composed of an alloy of a metal material M2 composed of at least one element selected from the group consisting of Fe, Co and Ni, and a metal material M3 composed of at least one element selected from the group consisting of Cr, Mo, W, V, Nb, Ta, Mn, Ti, Zr, Hf, Cu, Re, B, Al, Ga, In, C, Si, Ge, Sn, Pb, N, P, Bi, O, S, Se and Te.

Accordingly, the diffusion prevention layer 150 and the electrode member 120 can be stably joined to each other by the thermal stress relaxation layer 140. Further, it is possible to reduce the difference in thermal expansion coefficient between the diffusion prevention layer 150 and the p-type thermoelectric conversion member 111 and the difference in thermal expansion coefficient between the diffusion prevention layer 150 and the n-type thermoelectric conversion member 112.

In the embodiment, the content of the metal material M2 in the diffusion prevention layer 150 is, for example, equal to or more than 50 wt% and less than 100 wt%. In addition, the content of the metal material M3 is, for example, more than 0 wt% and equal to or less than 50 wt%.

For example, the diffusion prevention layer 150 is provided so as to be in contact with the thermal stress relaxation layer 140. In the embodiment, the diffusion prevention layer 151 is provided so as to be in contact with the thermal stress relaxation layer 141. The diffusion prevention layer 152 is provided so as to be in contact with the thermal stress relaxation layer 142. The diffusion prevention layer 153 is provided so as to be in contact with the thermal stress relaxation layer 143. The diffusion prevention layer 154 is provided so as to be in contact with the thermal stress relaxation layer 144. That is, in the embodiment, no layer other than the thermal stress relaxation layer 140 and the diffusion prevention layer 150 is provided between the p-type thermoelectric conversion member 111 and the electrode member 120 and between the n-type thermoelectric conversion member 112 and the electrode member 120.

Here, for example, the layer other than the thermal stress relaxation layer and the diffusion prevention layer refers to a layer for assisting joining between the thermal stress relaxation layer 140 and the diffusion prevention layer 150. Without providing such a layer, the diffusion prevention layer 150 is composed of the alloy of the metal material M2 and the metal material M3 and the thermal stress relaxation layer 140 is composed of the alloy of the metal material M4 and the metal material M5, and thus the thermal stress relaxation layer 140 and the diffusion prevention layer 150 can be stably joined to each other. That is, the electrode member composed of the alloy of Cu and the metal material M1 and the thermoelectric conversion member can be stably joined to each other.

The thermal expansion coefficient of the diffusion prevention layer 150 in a range of equal to or more than 20°C and equal to or less than 600°C is, for example, equal to or more than $8 \times 10^{-6}$ (/K) and equal to or less than $15 \times 10^{-6}$ (/K).

The difference in thermal expansion coefficient between the electrode member 120 and the diffusion prevention layer 150 in a range of equal to or more than 20°C and equal to or less than 600°C is, for example, equal to or less than 20% of the thermal expansion coefficient of the electrode member 120. Accordingly, the electrode member 120 and the diffusion prevention layer 150 can be stably joined to each other. For example, the diffusion prevention layer 150 is composed of the alloy of the metal material M2 and the metal material M3 so that such a thermal expansion coefficient is realized.

Here, the difference in thermal expansion coefficient between the electrode member and the diffusion prevention layer refers to an absolute value of a difference between the thermal expansion coefficient of the electrode member and the thermal expansion coefficient of the diffusion prevention layer.

For example, the thermoelectric conversion module 100 according to the embodiment is manufactured as follows.

First, the diffusion prevention layer 150 is integrally joined to the p-type thermoelectric conversion member 111 and the n-type thermoelectric conversion member 112. The diffusion prevention layer 150 is joined to the p-type thermoelectric conversion member 111 and the n-type thermoelectric conversion member 112 using, for example, a spark plasma sintering method, a thermal spraying method, a plating method, or a deposition method. In the embodiment, the diffusion prevention layer 150 is integrally joined to the p-type thermoelectric conversion member 111 and the n-type thermoelectric conversion member 112 under the conditions of, for example, a temperature of 500°C to 750°C, a pressure of 30 MPa to 60 MPa, and a sintering time of 5 minutes to 30 minutes in an inert gas atmosphere. Next, the integrated p-type thermoelectric conversion member 111 and diffusion prevention layer 150 is cut into p-type prismatic elements. In addition, the integrated n-type thermoelectric conversion member 112 and diffusion prevention layer 150 was cut into n-type prismatic elements.

Next, the electrode member 120 is joined to the diffusion prevention layer 150 of the p-type prismatic element and the diffusion prevention layer 150 of the n-type prismatic element. In the embodiment, for example, using the thermal stress relaxation layer 140 as a brazing filler material, the diffusion prevention layer 150 and the electrode member 120 are joined to each other. In the embodiment, for example, a step of joining the electrode member 120 to the diffusion prevention layer 150 is performed under the conditions of a temperature of 500°C to 750°C, a pressure of 1 MPa to 50 MPa, and a holding temperature of 10 minutes to 60 minutes in a vacuum or an inert gas atmosphere. Thus, the p-type prismatic element and the n-type prismatic element are connected by the electrode member 120. In the embodiment, for example, plural p-type prismatic elements and plural n-type prismatic elements are connected by the electrode member 120 such that the p-type prismatic elements and the n-type prismatic elements are alternately arranged.

In this manner, the thermoelectric conversion module 100 is obtained.

Next, the effects of the embodiment will be described.

According to the embodiment, the electrode member to be joined to the thermoelectric conversion member is composed of the alloy of Cu and the metal material M1 having a lower thermal expansion coefficient than that of Cu. When the electrode member includes Cu, an electrode member having good thermal conductivity and electrical conductivity can be realized. In addition, the electrode member includes the metal material M1 having a lower thermal expansion coefficient than that of Cu. Therefore, even when the electrode member includes Cu having a higher thermal expansion coefficient than that of Sb, the difference in thermal expansion coefficient between the electrode member and the thermoelectric conversion member can be reduced.

Further, the inventors have found that when the metal material constituting the electrode member has a phase-separated structure, the thermal expansion coefficient of the electrode member can be accurately adjusted. The electrode member of the embodiment includes two or more crystalline phases composed of Cu and the metal material M1. Thus, the balance between the properties required for the thermoelectric conversion module such as thermal conductivity and the thermal expansion coefficient can be accurately adjusted. Therefore, according to the embodiment, it is possible to improve durability while realizing the properties required for the thermoelectric conversion module.

(Second Embodiment)

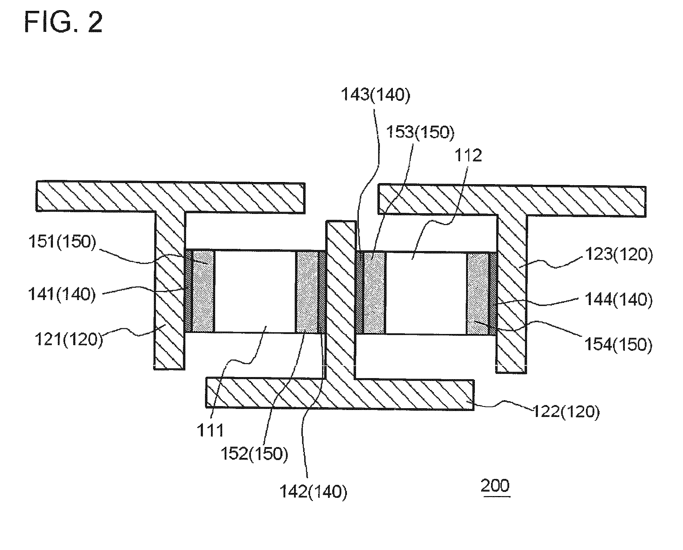

FIG. 2 is a schematic front view showing a thermoelectric conversion module 200 according to a second embodiment and corresponds to FIG. 1 of the first embodiment.

The thermoelectric conversion module 200 according to the second embodiment has the same configuration as the thermoelectric conversion module 100 according to the first embodiment except the connection structure between the p-type thermoelectric conversion member 111 and the n-type thermoelectric conversion member 112 and the electrode member 120.

In the thermoelectric conversion module 200 according to the embodiment, the p-type thermoelectric conversion member 111, the n-type thermoelectric conversion member 112 and the electrode member 120 have a Y-shaped connection structure.

In the Y-shaped connection structure, the p-type thermoelectric conversion member 111 and the n-type thermoelectric conversion member 112 are arranged in series with each other. That is, the p-type thermoelectric conversion member 111 and the n-type thermoelectric conversion member 112 are arranged such that the respective ends of the p-type thermoelectric conversion member 111 and the n-type thermoelectric conversion member 112 face to each other. The respective ends of the p-type thermoelectric conversion member 111 and the n-type thermoelectric conversion member 112 that face to each other are connected to each other through the electrode member 120.

For example, the thermoelectric conversion module 200 is configured such that plural pairs of p-type thermoelectric conversion members 111 and n-type thermoelectric conversion members 112 shown in FIG. 2 are connected in series with one another.

The electrode member 120 has a flat plate-like portion, and projection portion projecting from the flat plate-like portion toward a space between the facing ends of the p-type thermoelectric conversion member 111 and the n-type thermoelectric conversion member 112. The p-type thermoelectric conversion member 111 and the n-type thermoelectric conversion member 112 are connected to each other through the projection portion.

The electrode member 120 on a high temperature side is arranged such that the flat plate-like portion is disposed on the high temperature side (upper side in FIG. 2) as seen from the p-type thermoelectric conversion member 111 and the n-type thermoelectric conversion member 112. In addition, the electrode member 120 on a low temperature side is arranged such that the flat plate-like portion is disposed on the low temperature side (lower side in FIG. 2) as seen from the p-type thermoelectric conversion member 111 and the n-type thermoelectric conversion member 112. In the embodiment, for example, the electrode member 121 and the electrode member 123 are arranged on the high temperature side and the electrode member 122 is arranged on the low temperature side.

In the embodiment, for example, the flat plate-like portion configuring the electrode member 120 is provided in a flat plate-like shape. In this case, for example, the flat plate-like portion has a size of 5 mm×11 mm×0.5 mm to 2.0 mm. In addition, for example, the projection portion configuring the electrode member 120 is provided to have a flat plate-like shape in which the side surface is joined to the flat plate-like portion. In this case, for example, the projection portion has a size of 5 mm×6 mm to 11 mm×0.5 mm to 2.0 mm.

The electrode member 120 and the p-type thermoelectric conversion member 111, and the electrode member 120 and the n-type thermoelectric conversion member 112 are connected through the thermal stress relaxation layer 140 and the diffusion prevention layer 150, respectively. The thermal stress relaxation layer 140 and the diffusion prevention layer 150 of the embodiment has, for example, the same structure as the thermal stress relaxation layer 140 and the diffusion prevention layer 150 of the first embodiment.

In the embodiment, the same effects as in the first embodiment can be obtained.

The present invention is not limited to the above-described first embodiment and second embodiment and includes modifications, improvements and the like within a range capable of achieving the object of the present invention.

For example, a solid of revolution having a structure in which the thermoelectric conversion module shown in FIG.1 or 2 is rotated may be the thermoelectric conversion module according to the present invention. Specifically, a solid of revolution having a structure in which the thermoelectric conversion module 100 shown in FIG. 1 is rotated using a straight line extending to the horizontal direction in FIG. 1 and disposed in the upper portion or lower portion of the thermoelectric conversion module 100 as a rotation axis may be the thermoelectric conversion module according to the present invention. In addition, a solid of revolution having a structure in which the thermoelectric conversion module 200 shown in FIG. 2 is rotated using a straight line extending to the horizontal direction in FIG. 2 and disposed in the upper portion or lower portion of the thermoelectric conversion module 200 as a rotation axis may be the thermoelectric conversion module according to the present invention. At this time, the respective rotation bodies have a cylindrical shape. In this case, the axis of each solid of revolution becomes one of the high temperature side and the low temperature side in the thermoelectric conversion module and the outer edge becomes the other of the high temperature side and the low temperature in the thermoelectric conversion module. In addition, the p-type thermoelectric conversion member 111, the n-type thermoelectric conversion member 112, the electrode member 120, the thermal stress relaxation layer 140 and the diffusion prevention layer 150 respectively have a ring shape.

The upper portion and the lower portion of the thermoelectric conversion module 100 respectively correspond to the upper portion and the lower portion in FIG. 1. Further, upper portion and the lower portion of the thermoelectric conversion module 200 respectively correspond to the upper portion and the lower portion in FIG. 2.

(Examples)

Hereinafter, the thermoelectric conversion module of the present invention will be described in detail using examples. The thermoelectric conversion module of the present invention is not limited to the following contents and may be modified or changed within a range not departing from the category of the present invention.

Tables 1 and 2 show details of members respectively used in each Example and each Comparative Example. The references shown in Tables 1 and 2 correspond to references representing each configuration shown in FIG. 1.

The methods of preparing thermoelectric conversion modules in Examples 1 to 9 and Comparative Examples 1 to 3 will be described below.

First, the p-type thermoelectric conversion members 111, the n-type thermoelectric conversion members 112, the electrode members 121 to 123, the thermal stress relaxation layers 141 to 144, and the diffusion prevention layers 151 to 154 shown in Tables 1 and 2 were prepared. In each Example, the electrode members 121 to 123 were prepared by mixing pure metal powders having a particle diameter of equal to or less than 200 $\mu$m, and then performing a spark plasma sintering method (a type of powder metallurgy method) at a temperature of 900°C and a pressure of 30 MPa for sintering time of 10 minutes in vacuum. In each Comparative Example, the electrode members 121 to 123 were prepared by performing a spark plasma sintering method on pure copper powders having a particle diameter of equal to or less than 200 $\mu$m at a temperature of 900°C and a pressure of 30 MPa for sintering time of 10 minutes in vacuum.

Here, all of the electrode member 121, the electrode member 122 and the electrode member 123 prepared in each of Examples 1 to 9 had a phase-separated structure including a crystalline phase having Cu as a main component and a crystalline phase having a metal element other than Cu as a main component. The phase-separated structure had a sea-island structure in which one of the crystalline phase having Cu as a main component and the crystalline phase having a metal element other than Cu as a main component was formed like islands and the other was formed like the sea. Further, the maximum diameter of the circumscribed circle of the island-like component in the sea-island structure was equal to or less than 500 $\mu$m. The phase-separated structure was observed using a scanning electron microscope (SEM). The diameter of the circumscribed circle of the island-like component was calculated from an image obtained by SEM.

In each of the electrode members 121, the electrode members 122 and the electrode members 123 prepared in Examples 1 to 9, the content of O was equal to or less than 0.1 wt%, the content of As was equal to or less than 0.05 wt%, the content of Bi was equal to or less than 0.05 wt%, the content of S was equal to or less than 0.05 wt%, and the content of Sn was 0.05 wt% or less.

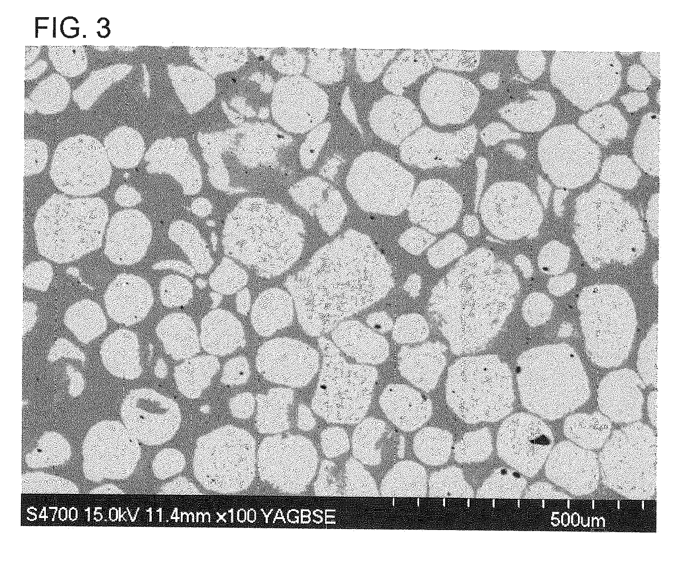

FIG. 3 is an SEM image (backscattered electron image) showing a phase-separated structure of the electrode member. In FIG. 3, the electrode member prepared in Example 1 is shown. As shown in FIG. 3, the electrode member prepared in Example 1 has a sea-island structure including an island-like crystalline phase having Cu as a main component and a sea-like crystalline phase having Cr as a main component. In addition, the maximum diameter of the circumscribed circle of the island-like component is equal to or less than 300 $\mu$m.

Next, using a spark plasma sintering method, under the conditions of a temperature of 700°C, a pressure of 50 MPa and a sintering time of 20 minutes in an inert gas atmosphere, diffusion prevention layers 151 and 152 were integrally joined to the p-type thermoelectric conversion member 111 and diffusion prevention layers 153 and 154 were integrally joined to the n-type thermoelectric conversion member 112, respectively. Next, the integrated p-type thermoelectric conversion member 111 and diffusion prevention layers 151 and 152 was cut into prismatic columns of 5 mmx5 mm×5 mm to obtain p-type prismatic elements. Further, the integrated n-type thermoelectric conversion member 112 and diffusion prevention layers 153 and 154 was cut into prismatic columns of 5 mmx5 mm×5 mm to obtain n-type prismatic elements.

Next, thirty two p-type prismatic elements and thirty two n-type prismatic elements were used, and the thirty two pairs of p-type prismatic element and n-type prismatic element were arranged in an area of 50 mm square. Next, the electrode members 121 were joined to the diffusion prevention layers 151 of the p-type prismatic elements using the thermal stress relaxation layers 141 shown in Table 1 or 2. In addition, the electrode members 122 were joined to the diffusion prevention layers 152 of the p-type prismatic elements using the thermal stress relaxation layers 142 shown in Table 1 or 2 and the diffusion prevention layers 153 of the n-type prismatic elements using the thermal stress relaxation layers 143 shown in Table 1 or 2. In addition, the electrode members 123 were joined to the diffusion prevention layers 154 of the n-type prismatic elements using the thermal stress relaxation layers 144 shown in Tables 1 or 2. The step of joining the electrode member to the diffusion prevention layer was performed under the conditions of a temperature of 650°C, a pressure of 2 MPa and a holding temperature of 30 minutes in an inert gas atmosphere. In this manner, in each of Examples 1 to 9 and Comparative Examples 1 to 3, a thermoelectric conversion module 100 having an area of 50 mm×50 mm and a height of 6 mm and a thermoelectric conversion module 200 having an area of 50 mm×50 mm and a height of 8.5 mm were obtained.

(Thermal Cycle Test)

A thermal cycle test was conducted on the thermoelectric conversion module 100 (at a thickness of 0.5 mm in the electrode members 121 to 123) in each Example and each Comparative Example. Specifically, a thermal cycle test was conducted in vacuum or in an inert gas atmosphere by using a block heater on a high temperature side and performing water cooling on a low temperature side and maintaining the temperature of equal to or lower than 50°C. The temperature of the electrode member on the high temperature side was raised from 200°C for 60 minutes and maintained at 600°C to 700°C for 30 minutes, and then controlled to drop to equal to or lower than 200°C in 60 minutes. This cycle was repeated until the number of completed cycles reached 100 in total. As a result, in each Example, there were no variation in power generation performance and no increase in internal resistance of the thermoelectric conversion module measured in each cycle, and it was proved that the joining was very satisfactory.

In Tables 1 and 2, the respective maximum electrical outputs and the internal resistances in a first thermal cycle and a hundredth thermal cycle in each Example and each Comparative example were shown. It was found that the maximum electrical output in the hundredth thermal cycle was equal to or more than 30 W and good powder generation performance was maintained after the thermal cycle test in each Example. On the other hand, it was found that the maximum electrical output in the hundredth thermal cycle was equal to or less than 25 W and the powder generation performance was deteriorated by the thermal cycle test in each Comparative Example. Further, it was found that the internal resistance in the hundredth thermal cycle was substantially the same as the internal resistance in the first thermal cycle and an increase in internal resistance was suppressed in each Example. On the other hand, it was recognized that the internal resistance in the hundredth thermal cycle was increased compared to the internal resistance in the first thermal cycle in each Comparative Example.

In each Example, a joining state of the thermoelectric conversion member and the electrode member after the thermal cycle test was observed and an element distribution was analyzed. As a result, the joining state was good, and mutual element diffusion between the thermoelectric conversion members and the electrode members was not recognized.

Further, a thermal cycle test was conducted on the thermoelectric conversion module 200 in each Example and each Comparative Example in the same manner as on thermoelectric conversion module 100. As a result, in each Example, there were no variation in power generation performance and no increase in internal resistance of the thermoelectric conversion module 200 measured in each cycle, and it was proved that the joining was very satisfactory.

From the above-described test results, in the thermoelectric conversion modules of Examples 1 to 9, it was confirmed that even when the temperature largely varied due to the operation of the thermoelectric conversion modules and the like, the joining between the p-type thermoelectric conversion members 111 and the n-type thermoelectric conversion members 112 and the electrode members 121 to 123 was maintained in a satisfactory manner. Accordingly, sufficient durability can be obtained in the thermoelectric conversion modules.

In addition, it was confirmed that high efficiency power generation was able to be stably performed in the thermoelectric conversion modules in Examples 1 to 9 even when temperature rising and dropping were repeated. In this manner, it was verified that it was possible to obtain sufficient power generation performance while improving the durability in the structure of the thermoelectric conversion module according to the present invention and the manufacturing method thereof.

[Table 1]

| Reference | Member name | Example 1 | Example 2 | Example 3 |
|---|---|---|---|---|
| 111 | p-Type thermoelectric conversion member | La0.7Ba0.01Ga0.1Ti0.1Fe3Co1Sb12 | La0.7Ba0.01Ga0.1Ti0.1Fe3Co1Sb12 | La0.7Ba0.01Ga0.1Ti0.1Fe3Co1Sb12 |
| 112 | n-Type thermoelectric conversion member | Yb0.3Ca0.1Al0.1Ga0.1In0.1Co3.75Fe0.25Sb12 | Yb0.3Ca0.1Al0.1Ga0.1In0.1Co3.75Fe0.25Sb12 | Yb0.3Ca0.1Al0.1Ga0.1In0.1Co3.75Fe0.25Sb12 |
| | p-Type and n-type thermoelectric conversion member size | 5×5×5mm | 5×5×5mm | 5×5×5mm |
| 121~123 | Electrode member | Cu50Cr50 (wt%) | Cu40Mo60 (wt%) | Cu30W70 (wt%) |
| | Electrode member size | 5×11×0.5mm | 5×11×0.5mm | 5×11×0.5mm |
| 141,142 | Stress relaxation layer | Ag56Cu22Zn17Sn5 (wt%) | Ag56Cu22Zn17Sn5 (wt%) | Cu79P7.8Ag6Sn7.2 (wt%) |
| 151,152 | Diffusion prevention layer | Fe78Cr17Si5 (wt%) | Fe70Ni10Mo15C2B1Si2 (wt%) | Fe65Co5Ni10W5Nb5Ta5 (wt%) |
| 143,144 | Stress relaxation layer | Ag56Cu22Zn17Sn5 (wt%) | Ag56Cu22Zn17Sn5 (wt%) | Cu79P7.8Ag6Sn7.2 (wt%) |
| 153,154 | Diffusion prevention layer | Fe82Cr13V5 (wt%) | Fe82Mo13Nb5 (wt%) | Fe82W13Ta5 (wt%) |
| Maximum electrical output and internal resistance in first thermal cycle | | 32.0W, 0.190Ω | 32.2W, 0.188Ω | 31.9W, 0.189Ω |
| Maximum electrical output and internal resistance in hundredth thermal cycle | | 32.0W, 0.190Ω | 32.3W, 0.187Ω | 31.8W, 0.190Ω |
| Reference | Member name | Example 4 | Example 5 | Example 6 |
| 111 | p-Type thermoelectric conversion member | La0.8Ba0.01Ga0.1Ti0.1Fe3.5Co0.5Sb12 | La0.8Ba0.01Ga0.1Ti0.1Fe3.5Co0.5Sb12 | La0.8Ba0.01Ga0.1Ti0.1Fe3.5Co0.5Sb12 |

(continued)

| Reference | Member name | Example 4 | Example 5 | Example 6 |
|---|---|---|---|---|
| 112 | n-Type thermoelectric conversion member | Yb0.2Ca0.1Al0.1Co4Sb12 | Yb0.2Ca0.1Al0.1Co4Sb12 | Yb0.2Ca0.1Al0.1Co4Sb12 |
| | p-Type and n-type thermoelectric conversion member size | 5×5×5mm | 5×5×5mm | 5×5×5mm |
| 121~123 | Electrode member<br>Electrode member size | Cu40V60 (wt%)<br>5×11×0.5mm | Cu45Nb55 (wt%)<br>5×11×0.5mm | Cu35Ta65 (wt%)<br>5×11×0.5mm |
| 141,142<br><br>151,152 | Stress relaxation layer<br>Diffusion prevention layer | Ag56Cu30Sn10Ni2Ti2(wt%)<br><br>Ni80Cr10V10 (wt%) | Cu83P7Ag6 (wt%)<br><br>Ni80Cr10Nb10 (wt%) | Al88Si12 (wt%)<br><br>Ni80Cr10Ta10 (wt%) |
| 143,144<br><br>153,154 | Stress relaxation layer<br>Diffusion prevention layer | Ag60Cu30Sn10 (wt%)<br><br>Fe80V20 (wt%) | Cu83P7Ag6 (wt%)<br><br>Fe80Nb20 (wt%) | Al88Si12 (wt%)<br><br>Fe80Ta20 (wt%) |
| Maximum electrical output and internal resistance in first thermal cycle | | 33.0W, 0.190Ω | 33.3W, 0.188Ω | 33.1W, 0.189Ω |
| Maximum electrical output and internal resistance in hundredth thermal cycle | | 32.9W, 0.190Ω | 33.4W, 0.187Ω | 33.2W, 0.190Ω |
| Reference | Member name | Example 7 | Example 8 | Example 9 |
| 111 | p-Type thermoelectric conversion member | La0.8Ba0.01Ga0.1Ti0.1Fe3Co1Sb12 | La0.8Ba0.01Ga0.1Ti0.1Fe3Co1Sb12 | La0.8Ba0.01Ga0.1Ti0.1Fe3.5Co0.5Sb12 |
| 112 | n-Type thermoelectric conversion member | La0.3Ca0.1Al0.1Ga0.1In0.2Co3.75Fe0.25Sb12 | La0.3Ca0.1Al0.1Ga0.1In0.2Co3.75Fe0.25Sb12 | La0.3Ca0.1Al0.1Ga0.1In0.2Co3.75Fe0.25Sb12 |

| Reference | Member name | Example 7 | Example 8 | Example 9 |
|---|---|---|---|---|
| | p-Type and n-type thermoelectric conversion member size | 5×5×5mm | 5×5×5mm | 5×5×5mm |
| 121~123 | Electrode member<br>Electrode member size | Cu50Cr40Mo5W5 (wt%)<br><br>5×11×0.5mm | Cu60Cr10Mo10W5V5Nb5Ta5 (wt%)<br><br>5×11×0.5mm | Cu65Cr10Mo5WSV5Nb5Ta5 (wt%)<br><br>5×11×0.5mm |
| 141,142<br><br>151,152 | Stress relaxation layer<br>Diffusion prevention layer | Ag56Cu22Zn17Sn5 (wt%)<br><br>Co80Cr15Si3Ge2 (wt%) | Ag56Cu22Zn17Sn5 (wt%)<br><br>Co50Fe20Ni10Cr15Si4Re1 (wt%) | A190Si10 (wt%)<br><br>Fe80Cr15Si4.5Pb0.5 (wt%) |
| 143,144<br><br>153,154 | Stress relaxation layer<br>Diffusion prevention layer | Ag56Cu22Zn17Sn5 (wt%)<br><br>Fe82Cr13V5 (wt%) | Ag56Cu22Zn17Sn5 (wt%)<br><br>Fe82Cr13V5 (wt%) | A190Si10 (wt%)<br><br>Fe82Cr13V5 (wt%) |
| Maximum electrical output and internal resistance in first thermal cycle | | 31.8W, 0.197Ω | 31.9W, 0.195Ω | 32.0W, 0.199Ω |
| Maximum electrical output and internal resistance in hundredth thermal cycle | | 31.7W, 0.197Ω | 32.0W, 0.194Ω | 32.1W, 0.199Ω |

EP 2 927 973 A1

[Table 2]

| Reference | Member name | Comparative Example 1 | Comparative Example 2 | Comparative Example 3 |
|---|---|---|---|---|
| 111 | p-Type thermoelectric conversion member | La0.7Ba0.01Ga0.1Ti0.1Fe3Co1Sb12 | La0.8Ba0.01Ga0.1Ti0.1Fe3.5Co0.5Sb12 | La0.8Ba0.01Ga0.1Ti0.1Fe3Co1Sb12 |
| 112 | n-Type thermoelectric conversion member | Yb0.3Ca0.1Al0.1Ga0.1In0.1Co3.75Fe0.25Sb12 | Yb0.2Ca0.1Al0.1Co4Sb12 | La0.3Ca0.1Al0.1Ga0.1In0.2Co3.75Fe0.25Sb12 |
| | p-Type and n-type thermoelectric conversion member size | 5×5×5mm | 5×5×5mm | 5×5×5mm |
| 121~123 | Electrode member | Cu | Cu | Cu |
| | Electrode member size | 5×11×0.5mm | 5×11×0.5mm | 5×11×0.5mm |
| 141,142 | Stress relaxation layer | Ag56Cu22Zn17Sn5 (wt%) | Ag56Cu22Zn17Sn5 (wt%) | Cu79P7.8Ag6Sn7.2 (wt%) |
| 151,152 | Diffusion prevention layer | Fe78Cr17Si5 (wt%) | Ni80Cr10Nb10 (wt%) | Ni80Cr10Ta10 (wt%) |
| 143,144 | Stress relaxation layer | Ag56Cu22Zn17Sn5 (wt%) | Ag60Cu30Sn10 (wt%) | Al88Si12 (wt%) |
| 153,154 | Diffusion prevention layer | Fe82Cr13V5 (wt%) | Fe80Nb20 (wt%) | Fe80Ta20 (wt%) |
| Maximum electrical output and internal resistance in first thermal cycle | | 32.0W, 0.190Ω | 32.2W, 0.188Ω | 31.9W, 0.189Ω |
| Maximum electrical output and internal resistance in hundredth thermal cycle | | 25.0W, 0.243Ω | 20.0W, 0.303Ω | 18.0W, 0.335Ω |

This application claims the benefit of priority of Japanese Patent Application No. 2012-260243, filed on November 28, 2012, the entire disclosure of which is incorporated herein by reference.

**Claims**

1. A thermoelectric conversion module comprising:

   a thermoelectric conversion member that contains Sb; and
   an electrode member that is joined to the thermoelectric conversion member, composed of an alloy of Cu and a metal material M1 having a lower thermal expansion coefficient than that of Cu, and includes two or more crystalline phases composed of Cu and the metal material M1.

2. The thermoelectric conversion module according to claim 1,
   wherein the metal material M1 is composed of at least one element selected from the group consisting of Cr, Mo, W, V, Nb and Ta.

3. The thermoelectric conversion module according to claim 1 or 2,
   wherein the electrode member has a sea-island structure in which any one of a crystalline phase having Cu as a main component and a crystalline phase having the metal material M1 as a main component is formed like islands and the other is formed like sea, and in the sea-island structure constituting the electrode member, a maximum diameter of a circumscribed circle of the island-like component is equal to or less than 500 $\mu$m.

4. The thermoelectric conversion module according to any one of claims 1 to 3,
   wherein the thermoelectric conversion member of a p-type and the thermoelectric conversion member of an n-type are provided, and
   a diffusion prevention layer composed of an alloy of a metal material M2 composed of at least one element selected from the group consisting of Fe, Co and Ni, and a metal material M3 composed of at least one element selected from the group consisting of Cr, Mo, W, V, Nb, Ta, Mn, Ti, Zr, Hf, Cu, Re, B, Al, Ga, In, C, Si, Ge, Sn, Pb, N, P, Bi, O, S, Se and Te is provided between the electrode member and the thermoelectric conversion member of the p-type and between the electrode member and the thermoelectric conversion member of the n-type.

5. The thermoelectric conversion module according to claim 4,
   wherein a thermal stress relaxation layer composed of at least one alloy selected from the group consisting of a Cu alloy, an Ag alloy and an Al alloy is provided between the diffusion prevention layer and the electrode member, and no layer other than the diffusion prevention layer and the thermal stress relaxation layer is provided between the thermoelectric conversion member and the electrode member.

6. The thermoelectric conversion module according to claim 4 or 5,
   wherein a difference in thermal expansion coefficient between the electrode member and the diffusion prevention layer in a range of equal to or more than 20 °C and equal to or less than 600 °C is equal to or less than 20% of a thermal expansion coefficient of the electrode member.

7. The thermoelectric conversion module according to any one of claims 1 to 6,
   wherein a content of O in the electrode member is equal to or less than 0.1 wt%.

8. The thermoelectric conversion module according to any one of claims 1 to 7,
   wherein a content of As in the electrode member is equal to or less than 0.05 wt%.

9. The thermoelectric conversion module according to any one of claims 1 to 8,
   wherein a content of Bi in the electrode member is equal to or less than 0.05 wt%.

10. The thermoelectric conversion module according to any one of claims 1 to 9,
    wherein a content of S in the electrode member is equal to or less than 0.05 wt%.

11. The thermoelectric conversion module according to any one of claims 1 to 10,
    wherein a content of Sn in the electrode member is equal to or less than 0.05 wt%.

**12.** The thermoelectric conversion module according to any one of claims 1 to 11,
wherein the thermoelectric conversion member is composed of a non-filled skutterudite compound.

**13.** The thermoelectric conversion module according to any one of claims 1 to 11,
wherein the thermoelectric conversion member is composed of a filled skutterudite compound.

**14.** The thermoelectric conversion module according to claim 13,
wherein the thermoelectric conversion member is composed of a compound expressed by a formula
$R_r T_{t-m} M_m Sb_{x-n} N_n$ ($0 \leq r \leq 1$, $3 \leq t-m \leq 5$, $0 \leq m \leq 0.5$, $10 \leq x \leq 15$, $0 \leq n \leq 2$),
R represents three or more elements selected from the group consisting of rare earth elements, alkali metal elements,
alkaline-earth metal elements, group 4 elements, and group 13 elements,
T represents at least one element selected from Fe, Co and Ni,
M represents at least one element selected from the group consisting of Ti, V, Cr, Mn, Cu, Zn, Ag and Au, and
N represents at least one element selected from the group consisting of P, As, Bi, O, S, Se, Te, C, Si, Ge, Sn and Pb.

**15.** The thermoelectric conversion module according to any one of claims 1 to 14,
wherein a difference in thermal expansion coefficient between the electrode member and the thermoelectric conversion member in a range of equal to or more than 20°C and equal to or less than 600°C is equal to or less than 20% of a thermal expansion coefficient of the thermoelectric conversion member.

## FIG. 1

122(120)
143(140)
142(140)
153(150)
152(150)
112
111
151(150)
154(150)
141(140)
144(140)
121(120)
123(120)
100

FIG. 2

FIG. 3

S4700 15.0kV 11.4mm x100 YAGBSE          500um

**INTERNATIONAL SEARCH REPORT**

| International application No. |
| --- |
| PCT/JP2013/082063 |

A. CLASSIFICATION OF SUBJECT MATTER
See extra sheet.

According to International Patent Classification (IPC) or to both national classification and IPC

B. FIELDS SEARCHED

Minimum documentation searched (classification system followed by classification symbols)
H01L35/32, C22C5/08, C22C9/00, C22C9/01, C22C9/04, C22C9/10, C22C12/00, C22C19/05, C22C19/07, C22C21/00, C22C21/12, C22C27/02, C22C27/04, C22C27/06, H01L35/08, H01L35/18

| Documentation searched other than minimum documentation to the extent that such documents are included in the fields searched | | | |
| --- | --- | --- | --- |
| Jitsuyo Shinan Koho | 1922–1996 | Jitsuyo Shinan Toroku Koho | 1996–2014 |
| Kokai Jitsuyo Shinan Koho | 1971–2014 | Toroku Jitsuyo Shinan Koho | 1994–2014 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| Y | JP 2011-249492 A (Furukawa Co., Ltd.), 08 December 2011 (08.12.2011), paragraphs [0011] to [0014], [0049] to [0054], [0070]; fig. 1 (Family: none) | 1-15 |
| Y | JP 2000-239762 A (Furukawa Co., Ltd.), 05 September 2000 (05.09.2000), paragraphs [0010], [0015] (Family: none) | 1-15 |

☐ Further documents are listed in the continuation of Box C.   ☐ See patent family annex.

| | |
| --- | --- |
| * Special categories of cited documents:<br>"A" document defining the general state of the art which is not considered    to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| 20 February, 2014 (20.02.14) | 04 March, 2014 (04.03.14) |

| Name and mailing address of the ISA/ | Authorized officer |
| --- | --- |
| Japanese Patent Office | |
| Facsimile No. | Telephone No. |

Form PCT/ISA/210 (second sheet) (July 2009)

**INTERNATIONAL SEARCH REPORT**

International application No.

PCT/JP2013/082063

Continuation of A. CLASSIFICATION OF SUBJECT MATTER
 (International Patent Classification (IPC))

*H01L35/32*(2006.01)i, *C22C5/08*(2006.01)i, *C22C9/00*(2006.01)i,
*C22C9/01*(2006.01)i, *C22C9/04*(2006.01)i, *C22C9/10*(2006.01)i,
*C22C12/00*(2006.01)i, *C22C19/05*(2006.01)i, *C22C19/07*(2006.01)i,
*C22C21/00*(2006.01)i, *C22C21/12*(2006.01)i, *C22C27/02*(2006.01)i,
*C22C27/04*(2006.01)i, *C22C27/06*(2006.01)i, *H01L35/08*(2006.01)i,
*H01L35/18*(2006.01)i

      (According to International Patent Classification (IPC) or to both national
      classification and IPC)

Form PCT/ISA/210 (extra sheet) (July 2009)

**EP 2 927 973 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2011249492 A
- WO 2009093455 A
- JP 2012522380 PCT
- JP 2012260243 A